Europäisches Patentamt

(19) European Patent Office

Office européen des brevets

(11) Publication number: **0 092 303**
**B1**

(12) **EUROPEAN PATENT SPECIFICATION**

(45) Date of publication of patent specification: **01.10.86**

(21) Application number: **83300982.2**

(22) Date of filing: **24.02.83**

(51) Int. Cl.⁴: **G 01 R 35/04**

(54) **Meter testing device and method.**

(30) Priority: **05.03.82 US 354149**

(43) Date of publication of application:
**26.10.83 Bulletin 83/43**

(45) Publication of the grant of the patent:
**01.10.86 Bulletin 86/40**

(84) Designated Contracting States:
**AT BE CH DE FR GB IT LI LU NL SE**

(56) References cited:
**US-A-2 550 818**
**US-A-2 557 314**
**US-A-2 938 165**
**US-A-3 543 149**
**US-A-4 271 390**

(73) Proprietor: **SOUTHERN CALIFORNIA EDISON COMPANY**
**2244 Walnut Grove Avenue**
**Rosemead California 91770 (US)**

(72) Inventor: **Phillips, Charles Edward**
**2400 South Roark Drive**
**Alhambra California 91803 (US)**
Inventor: **Hood, Alan Merle**
**515 Way Court**
**San Dimas California 91773 (US)**

(74) Representative: **Harrison, David Christopher**
**et al**
**MEWBURN ELLIS & CO 2/3 Cursitor Street**
**London EC4A 1BQ (GB)**

## Description

This invention relates to a meter testing device, particularly an electric watt-hour meter. The invention is particularly concerned with verifying the operational accuracy of such watt-hour meters.

Electricity supply companies are often requested by users of electrical power to ascertain and prove the accuracy of the watt-hour meter which reads the amount of electricity being consumed by the customer. To satisfy such customers the utility companies send a skilled testman to the operational site and through fairly complex operational techniques the meter accuracy is tested. It is recognized that the accuracy of the meter is within a standard of error of 2%, and in the event of the meter being inaccurate to a degree greater than this, then procedures have to be followed at the operational site to have the meter rectified.

At manufacturing and laboratory locations electric watt-hour meter testing and calibration require skilled, technical operators who operate highly sophisticated and complex equipment, and it is clearly not feasible to use such equipment at different operational sites.

Inherently, therefore, it is desirable to provide a watt-hour meter testing apparatus and a method for testing such meters which is relatively simple by nature, so that verification at the operational site can be made by relatively unskilled testmen or meter readers. At the same time the testing apparatus should be able to provide the user at the operational site with simple verifiable evidence as to the accuracy or otherwise of the meter under test. None of this is to date possible with the known meter testers and methods of determining accuracy.

In U.S. Patent 4,271,390 (Canu), (Figure 5 of which is considered herein as the closest starting-point for the present invention), there is disclosed a self-contained portable meter testing device wherein an adapter is inserted by means of line terminals into a meter receiving socket and the meter under test is then fitted into load terminals in the adapter. With the adapter are means for measuring the volts or wattage passing through a known load, the load being a standard light bulb connected to the adapter, and wattage being displayed on a meter. A comparison therefore of the displayed wattage relative to the bulb's rated power characteristics is the indication of the accuracy of the meter. With this device, however, the power supply lines are isolated from the normal operational load and this leads to inconvenience at the operational site. Additionally the load in the form of a standard light bulb is relatively very low compared to the normal operational load and thus read by the meter. Thus the degree of accuracy obtained by this prior art device is not representative of normal conditions and is thus relatively poor.

In U.S. Patent 2,249,075 (Young), there is disclosed an adapter which can be interposed between a meter socket and a meter and to which a suitable measuring instrument can be connected. This device however does not indicate that the deivce could be used for loading the meter in any way and/or obtaining a verification of the meter.

In U.S. Patent 2,938,165 (Greig) there is disclosed the standard method for testing meters in a laboratory whereby a standard meter and a meter under test are effectively connected with a loading transformer with different loading situations. This complex testing procedure requires two meters: the standard meter puts out pulses according to the revolutions of the meter disc, and the meter under test likewise puts out pulses according to light passing through an aperture of its revolving disc. The relative pulse counts are compared and a reading of accuracy is obtained in the form of indicating the percentage registration of the meter under test. The test disclosed in this patent requires that the speed ratios of the standard meter and tested meter are the same. Accordingly, different standard meters are required to test different meters being verified. The application of the disclosed test is therefore limited to specific apparatus. The photo pickup which is used to pass light through the aperture in the meter under test is suitable for operation under laboratory conditions. However, this photo pickup method has never been found applicable in practice in the prior art for use at outdoor operational sites since there are ambient light conditions which impact greatly on the light between the generating source and receiving means thereby affecting the signal picked up by the receiver. Consequently, to date it has been necessary to count revolutions of the disc in the field simply by visibly detecting a black mark on the outer perimeter of the disc and physically counting the number of revolutions by counting the number of times that the dot passes. This is susceptible to inaccuracies.

A sample of prior art known for calibrating a watt-hour meter in a laboratory exists in U.S. Patent 3,409,829 (Elmore), where there is disclosed a computer controlled callibration test rack and from which it is clear that laboratory testing of meters is complex and not amenable to use in operational sites by relatively unskilled testmen.

U.S. Patents 4,120,031 (Kincheloe), 4,133,034 (Etter), 4,224,671 (Sugiyama), 4,240,149 (Fletcher), and 4,283,772 (Johnston) disclose various forms of electronically monitoring and calculating characteristics associated with power usage through watt-hour meters.

In the commercial field, E. J. Brooks Company of Michigan markets a meter evaluator under the trade name EKSTROM wherein the evaluator places a high load on the meter and a fixed number of revolutions of the meter disc is timed. Calculations are then made by inserting the time interval into a percentage registration formula and then determining the percentage of registration of the meter. The load applied to the meter is in the form of two hair drier type motors and heating coils, and thus this is a noisy test device and heavy on its loading requirements, thus producing excessive heat.

Another commercially available system is that produced by System Jett of North Carolina who provide a Calibration Checker, model SJ621, which requires inserting an adaptor with a standard meter and a meter under test into the meter receiving socket. Simultaneously electronically comparing the readings through the meters are obtained such that the kilowatt hours of each meter are obtained, and also the percentage registration of the meter under test is ascertained.

In the tester known commercially as the "The Average Beast", H. J. Arnett Industries, Inc. of Portland, Oregon places an adaptor into the meter socket and then puts the meter into the adaptor. After timing a predetermined number of disc revolutions, readings are compared against a tabulated set of figures to ascertain the percent registration of the meter. In the application of this verifier the power between the line and operational load is broken, and additionally the disadvantage of manual calculation is necessary.

In yet a further commercial device, the ACCU-VER verifier marketed by Custom Terminals Corp. of Hauppange, New York locates an adapter between the meter receiving socket and the meter and then applies a test with a known load to the meter. Thereafter after timing the meter disc for one or more revolutions, there is obtained a rough accuracy check.

In US—A—3543149, a meter testing arrangement includes a constant load which is interposed electrically between the line and the meter by means of line and load terminals.

None of the cited art however provides for meter verification which is simple to apply by non-skilled personnel at an operational site, nor does any apply a phantom load to the meter such that verification of a higher load under normal operating conditions can be obtained.

Furthermore, the prior art does not disclose effective light generating and receiving means which is operational with a rotating disc of the meter whereby accurate determinations of the watt-hours in the meter can be made at the operational site. Also non-existent in the prior art is the means of calculating the percentage error of the meter under test under the representative real load conditions, and displaying such representative error as a percentage.

The invention is distinguished from US—A—4271390 in that a phantom load representative of a higher load to the meter is applied to the meter under test from a loading transformer, and also to a watt-transducer. Thereafter the actual watt-hours are determined by the watt-transducer over a time period, e.g. for a predetermined number of meter disc revolutions, and are compared with the watt-hours indicated by the meter. These may be used to compute digitally the percentage error of the meter.

The revolutions of the meter disc may be determined by a light passing from a light generating source through a disc aperture when such aperture is aligned with the source and receiving means located on the opposite sides of the disc.

A particular embodiment will be described with reference to the accompanying drawings wherein:

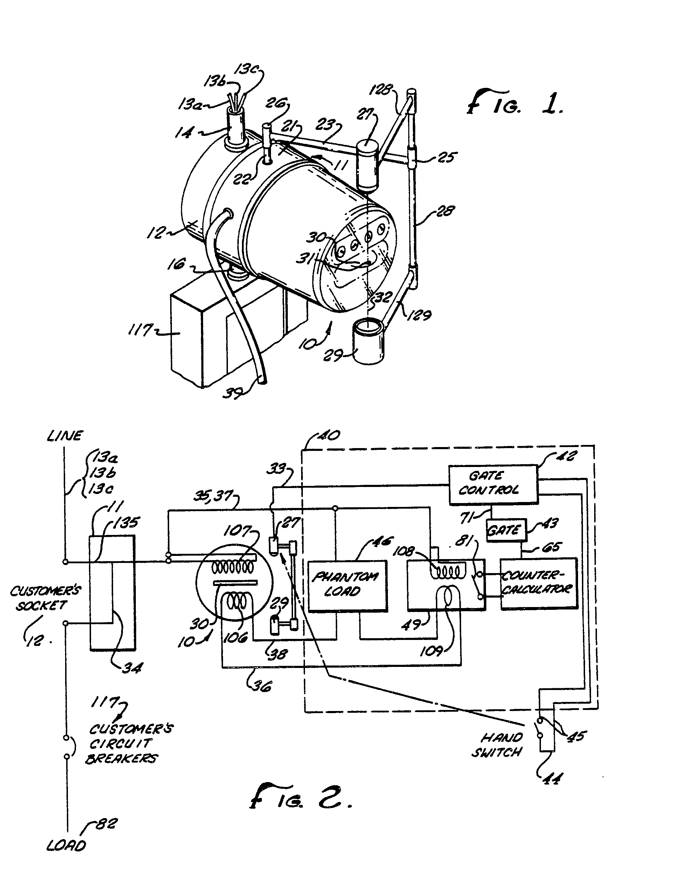

Figure 1 is an isometric view of the meter receiving socket together with an adaptor and the meter fitted on the adaptor, and showing electrical conductors from the adaptor;

Figure 2 is a block diagram-schematic of the meter accuracy apparatus in connection with the supply lines;

Figure 3 is a schematic illustrating the connection of the loading transformer in the verifying apparatus to the adaptor and watt-transducer, the apparatus being shown in a carrying case;

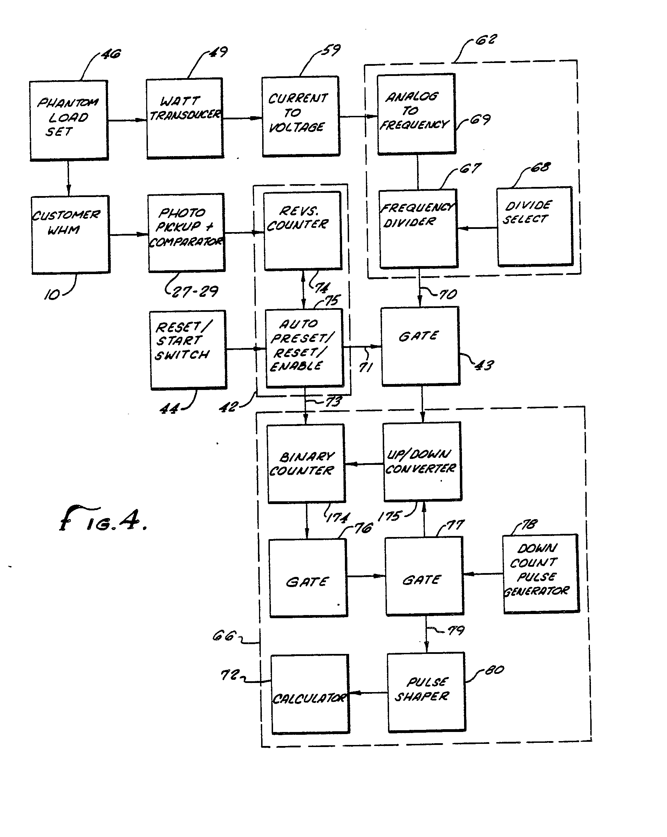

Figure 4 is a block diagram of the schematic block diagram representing the manner in which signals obtained from the operational watt-hour meter and the watt-transducer are translated, compared and computed to obtain a reading of the percentage error of the meter.

Apparatus for testing the accuracy of a watt-hour meter 10 at its operational site includes an adapter 11 for location between the meter 10 and a meter receiving socket means 12. The power lines 13a, 13b, and 13c enter the meter receiving socket 12 through a conduit means 14 which communicates with the interior of the meter receiving socket 12. The load lines 15 leave the socket 12 through a conduit means 16 and enter a circuit breaker arrangement contained within circuit breaker box 117.

The meter 10 is shown in phantom lines in Figure 3 and it provides terminal blades 17 which normally would fit within the terminal jaws 18 in the meter receiving socket 12. The adapter 11 provides at one end blades 19 which are adapted to fit into the jaws 18 of the meter receiving socket 12 and jaws 20 at its opposite end which are arranged to receive the blades 17 of the meter 10.

Mounted on the casing 21 of adapter 11 at its uppermost portion is a vertical conduit 22 which has an articulated arm arrangement consisting of a portion 23 which is pivoted about a pivot arrangement 25. The portion 23 is also pivoted with a coupling 26 on the vertical conduit 22.

Hingedly mounted at the end of arm 23 is a vertical arm 28 which has two spaced apart horizontal limbs 128 and 129. At the end of limb 128 is a light generating source 27 which is rigidly connected to limb 128, and at the end of limb 129 there is mounted a light receiving means 29 also rigidly connected to the limb 128 so that the generating source 27 and receiving means 29 face toward each other. With the articulated mechanism the generating source 27 and receiving means 29 can be located at the top and bottom of the meter 10 respectively so that a revolving disc 30 in the meter 10 is located between the generating source 27 and receiving means 29. In other embodiments the light receiving means 29 and light generating means 27 are in the opposite locations relative to the disc 30.

The revolving disc 30 includes an aperture 31 and with the disc 30 revolving in a horizontal plane light from the generating source 27 can pass axially as indicated by line 32 to the receiving means 29 through the aperture 31 when such aperture 31 is aligned along the axial line 32. With the disc 30 in a different position of its revolution the light is interrupted. Within the articulated arm structure 22, 23, 28, 128 and 129 there is contained a cable 33 which passes a signal from the receiving means 29 into the adapter 11 and in turn to other apparatus of the verifier. The cable 33 also contains wires to the light generating source 27 and light receiving means 29.

The light generating source 27 is a high intensity quartz-halogen light with a lens concentrating system and the receiving means 29 has a lens arrangement for receiving light from the generating source 27. In view of the verifier operating for relatively short time periods for each verification it has been found that the high heat which would normally be generated by the high intensity light source 27 does not in fact occur and the apparatus does not rise to a temperature which would be a drawback to effective operation. Hence for the first time it is now possible to employ an effective light means in the field at operational sites to count disc revolutions.

The line supply is a three conductor conduit wire system, line 13a being a grounded wire and lines 13b and 13c carrying voltages of 120 volts each respectively. In the adapter 11, blades 19 are connected by conductors 34 so that power can pass to the electrical load terminals and thus power at 120 volts and 240 volts is continually supplied to the customer load 82 at the operational site. The power to the adapter is at 240 volts passing along conductor lines 135 which are connected with the top terminal jaws 20 of the adapter 11 as indicated. The jaws 20 respectively connect with the mating blades 17 on the meter 10 and in this fashion the meter is supplied with power at 240 volts.

Conductor lines 35, 36, 37 and 38 are connected with the jaws 20 of the adapter 11 and pass through the adaptor housing in a cable sheath 39 together with the cable 33 from the light generating 27 and receiving means 29. The cable 39 enters a storage box or case 40 which has a compartment 41 for storing the adapter 11 and articulated arm mechanism when not in use.

Cable 33 is connected with a gate control means 42 which operates gate 43. The gate control means 42 is connected with a stop-start hand switch 44 by means of lines 45.

Lines 35, 36, 37 and 38 which are connected to the terminals 20 of the adapter 11 are connected to the loading transformer 46 which provides a phantom load to the meter 10. The loading transformer 46 includes a pair of coils 144 and 145 which form one side of the transformer and the second side of loading transformer 46 is constituted by winding 47. There is also included a load adjustment resistor 48 in the circuit of the winding 47 of the second winding 47 of loading transformer 46 whereby the phantom load on the meter 10 can be varied. Alternatively a variable voltage transformer such as a Variac (TM) can functionally replace variable resistor 48.

The lines 35, 36, 37 and 38 are connected to the load transformer 46 through connection with terminals 50, 51, 52 and 53 of a watt transducer 49. In this embodiment the watt transducer is a 3 phase, 2-element transducer; however, in alternative arrangement a single element transducer could be used with an appropriate transformer. The selected transducer requires isolation between the two power legs originating from lines 13b and 13c. The isolation is shown between terminals 50 and 51 on the one hand, and terminals 52 and 53 on the other hand. By this connection, the phantom load is also applied to the watt-transducer 49.

The output of the watt transducer 49 is a signal which is a milliamp current proportional to the wattage derived from the current terminals 50, 51, 52 and 53 and the voltage on terminals 101 and 102. Terminals 100 and 102 of the watt transducer 49 are connected together, and terminals 101 and 103 of the watt transducer are also connected together. These terminals 100, 101 are voltage inputs to the watt transducer 49 corresponding to the current inputs 40 and 51, terminal 50 being connected to terminal 100 so to apply the voltage from being connected to terminal 100 so to apply the voltage from line 13b. Terminals 102 and 103 are voltage inputs corresponding to the current inputs 52 and 53, terminal 103 to terminal 104 so to apply a voltage from line 13c.

There is connected across the output terminals 58 a potentiometer 59 which translates the current value to a voltage value across lines 60 which is then proportional to the wattage across the watt-transducer 49. The potentiometer 59 also permits calibration of transducer 49 as required.

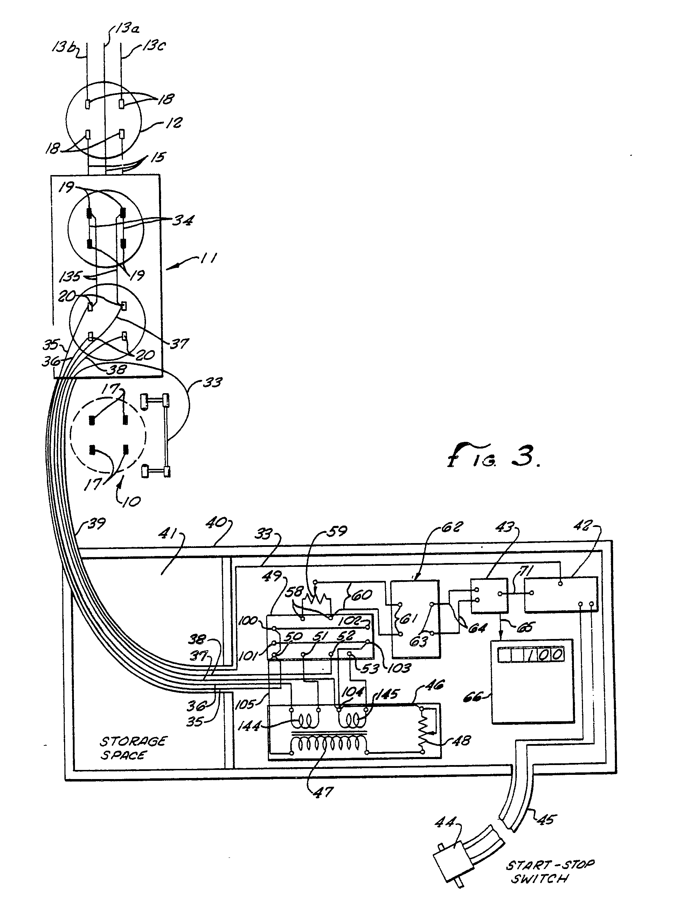

In the block-diagram schematic of Figure 2, only a single current coil 106 is shown in the meter 10, whereas there are in practice two such coils 106. There is also shown a single voltage coil 107, and in practice there is only such a single coil 107. In this Figure 2, lines 35 and 37 are shown connected to both the phantom load 46 and watt transducer 49, through coil 108. The coil 108 is also illustrative of one of the two coils 108 which exist in practice. One of which coils 108 would be connected to terminals 100 and 101, on the one hand, and the other of coils 108 would be connected to terminals 102 and 103, on the other hand. In Figure 2 the coil 109 in the watt transducer 49 is also illustrative of two coils 109 which would exist in practice; one of which could be connected across terminals 50 and 51, and the other across terminals 52 and 53 respectively. One of the coils 109 is connected to coil 106 through conductors 36 and 38. In this Figure the second coil 109 (not shown) is connected through conductors 35 and 37 (not shown, in this sense) with the second coil 106 (not shown) in the meter 10. However this connection would follow a similar path to that shown for conductors 36 and 38 in Figure 2, and these conductors, connections and coils have been omitted solely in the interests of understanding the Figure 2. To anyone skilled in this art these connections would be clearly apparent in view of what has been described and illustrated. In Figure 2 the phantom load is only illustratively indicated, and the details with both the coils are shown and described in Figure 3 as coils 144 and 145. One of each of the coils 144 and 145 are connected in series with the coils across terminals 50 and 51; and 52 and 53 respectively of the watt transducer 49, and, in this manner, the conductors 36 and 38 are connected to the coils 144 and 145.

With the lines 35, 37 from adapter 11 there is effectively connected across the primary winding 47 of loading transformer 46, a nominal 240 volt supply. Any difference from 240 volts could be dropped across the resistor 48. The connection of line 35 to the primary winding 47 passes through line 105, and the connection of line 37 passes through resistor 48 to the primary winding 47. Lines 36 and 38 complete the current circuit for the secondary side of loading transformer 46.

The lines 60 are connected to the input terminals 61 of an analog to digital converter 62 and the output terminals 63 of this converter 62 are connected by lines 64 to the gate 43. The output of the gate 43 is connected by lines 65 to counter calculating means 66 to provide information representative of the accuracy of the meter 10.

The analog-digital converter 62 includes a frequency divider 67 and a divide-select 68 which allows the testing apparatus to be adjusted for the sensitivity of the particular meter 10 under test. In this connection each meter 10 has its own meter constant and this relates to the operational characteristics of the meter and also translates into the number of times that the disc 30 revolves relative to the consumption of kilowatt hours. Thus, a meter with a constant ($K_h$) of 7.2 would rotate 1 revolution per 7.2 watt hour. The divide-select 68 therefore permits variations of the meter characteristic to be programmed into the system, such as, for example, between 7.2, 3.6, 2.0 and 1.0. In this fashion the calculation of watt hours in the analog-digital converter 62 and further into the calculator means 66 will be a comparative figure relative to the revolutions of the disc 30 as picked up by the light receiving means 29 and then related to the gate control circuit 42.

Also within the analog-digital converter 62 is an analog to frequency converter 69 which cooperates with the frequency divider so that the output from the analog-digital converter 62 as depicted on line 70 is a train of pulses having a frequency proportional to the watt transducer output. This is applied to the gate 43.

The hand operated switch 44 through the gate control means 42 enables the gate 43 by signals along the line 71, thus allowing the output from the converter 62 to be applied to the calculator means 66. The gate control 42 counts the number of pulses from the receiving means 29 and, once a predetermined number of pulses are received corresponding to a predetermined number of revolutions of the meter disc 30 disables the gate 43. In this manner the gate control means 42 enables the gate 43 for a number of watt hours corresponding to a predetermined number of turns of the rotating disc 30. A calculator 72 then digitally displays the percentage error of watt hour meter 10 as a result of the total number of pulses counted from the receiving means 29 and a comparison with the power measured by the watt transducer 29 as suitably converted.

The calculating means 66 is described with support circuitry to adapt a relatively inexpensive hand calculator 72 to be responsive to the pulses from line 73 as received from the revolution counter 74 and switch means 75 which either automatically operates the gate control means 42 or operates manually as determined by hand switch 44. The gate 43 determines the enablement of the calculator means 66. The circuitry of the calculator means 66 also adapts the pulses along line 73 to a signal which can be counted by calculator 72 which responds to a relatively slow input. This circuitry includes a binary counter 174, an up-down convertor 175, gate 76, and gate 77, which gate 77 is also fed by down-count pulse generator 78. The output from gate 77 along line 79 is to a pulse shaper 80 which then outputs to the calculator 72.

The down count pulse generator 78 of the support circuitry is a frequency generator operating at near the maximum operating frequency of the calculator input, and is enabled during memory down-count operation by the binary counter 174. The puse shaper 80 provides a positive edge triggering pulse with a minimum pulse duration to trigger the calculator 72 in the manner described.

With the arrangement of the invention the calculator is arranged initially to display digitally "100" which represents 100% possible error when comparing the meter 10 watt-hour registration as against the watt transducer 49 watt-hour registration for the period of test. As the calculation process takes place in the calculating means 66 through the input of the down-count pulse generator 79 that sequentially subtracts a fractional error factor from the total possible error, the "100" digital display reduces to a final figure which would represent ultimate percentage error of the watt hour meter 10. Thus, if the final figure is "1.1", the percentage error is one and one-tenth percent plus. By the term "plus" it is meant that the watt hour meter is reading more than the true energy. If the reading is "negative" it would mean that the meter 10 is reading less energy than actually consumed.

When the term "accuracy" is used in this application it refers to either the percentage error, or the degree with which the meter shows the percent registration as a deviation from true energy through the meter. Thus a calculator reading of minus 2.1 would represent a percentage error of 2.1% negative; and in alternative embodiment if the calculator displays 102.1 this represents an error in the meter under test of 2.1% negative.

The support circuitry of the calculating means 66 can be replaced by micro-processors, and such micro-processors could also include some of the other circuit elements contained within the analog-digital converter 62, gate 43 and gate control means 42. With microprocessors even more enhanced error readings can be obtained.

With the apparatus of the invention the adapter 11 allows the customer to continue using energy but at the same time isolates the meter 10 which is under test from service except for the 240 voltage power. Such energy which the customer would be using would not be metered.

The meter 10 under test is artificially or phantom loaded by the loading transformer 46 in that it sees an artificially high load, for instance, 3.6 kilowatt (15 amps × 240 v). However, the test apparatus actually consumes only a small portion of this actual power. This permits the meter under test 10 to be verified at realistic operational type conditions.

The test apparatus employs a high quality solid state watt transducer 49 which "sees" the same phantom load as the meter 10 and this comparison between the watt-hour reading on the meter 10 and that obtained from the watt transducer 49 as suitably translated through the electronic circuitry provides the percentage error that is required in the verification.

The watt transducer output ultimately outputs, as the equivalent of a relay contact rate of closure depicted illustratively by relay 81, a signal which is accurately proportional to the kilowatt hours being introduced to the customer's meter. Repeated contact closures on illustrative relay 81 are summed in the calculator 66 taking account of the disc constant $K_h$ of the customer's meter 10. Relay 81 may be a mechanical switch or a solid state equivalent relay.

In use, the apparatus requires removing the meter 10 from the meter receiving socket 12, connecting the adapter 11 into the socket 12 and thereafter installing the meter 10 into the adapter 11. The apparatus is energized when plugged into the socket 12 and the meter disc 30 rotates. Optionally switch means can be used to insure energization only when required. The calculator means 66 is programmed for the value of the particular meter and, when using the manual operation mode, the start-stop test switch 44 is closed by hand when a black disc spot passes a particular reference point. The meter disc revolutions are counted for the prescribed number of revolutions, for instance, ten, and the switch 44 opened again manually when the black spot reappears signifying completion of the number of requisite revolutions. At the end of the test the calculator display starts counting down from a "100" towards "0" and stops at a figure representing the percentage error of the meter 10.

In the alternative automatic arrangement the switch 44 is replaced by the enabling gate control circuitry 42 the counting does not commence until the aperture 31 appears in alignment between the source generating means 27 and receiving means 29 so that a light signal is received by the receiving means 29. In this manner counting takes place automatically and there is less room for human error. After a predetermined number of revolutions the switch circuitry 75, stops the count automatically by directing gate 43 and the calculation of percentage error is effected.

Although the invention has been described with reference to a 240 voltage three wire single-phase system clearly it is also applicable to other wiring systems such as 120 volt two wire system. The differences in the meter constant ($K_h$) for such systems as applicable can also be entered into the electronic calculations of the system and thus the verifier is highly utile for simple operation at customer sites by unskilled operators.

Furthermore, although the percentage accuracy has been shown as counting downwardly from 100% error to a lower percentage error, it is clear that the display could be the opposite way and that the percentage accuracy can be depicted or a form of registration from zero upwardly to one hundred percent or more.

With the test apparatus it is easy for an unskilled operator to perform the requisite verification. After a meter has been tested and an error reading recorded, it is only necessary for the operator to simply reactivate the switch manually by switch 44 or through the auto switching means 75 and retest the meter again, and as often as necessary, to insure accurate verification.

Furthermore it is possible to simulate the different loading on the meter by having range settings as governed by resistor 48 whereby the phantom load presents an artificial drawing of current for high, medium and low load conditions, for instance, where the current is in the range of between 30 amps and 5 amps. Thus, where the phantom load is in the order of 60 watts there is artificially presented to the meter 10 and the watt transducer 49 a load where the current is 30 amps. The meter 10 and watt transducer 49 in this situation will "see" 7.2 kilowatts of power in a 240 volt three wire system.

There is thus, with this invention, provided a simple manner for digitally displaying meter error under realistic test conditions without energy waste, heat dissipation or noise problems, and at the same time retain the consumer power supply connection, which are all among the problems which arise in prior art systems.

The described embodiment has concerned a single phase unit; however, the invention is also applicable to multiphase meters. Phantom loads can be applied to each phase of the multiphase system and to watt transducers in each phase, and suitable means can be provided for determining the accuracy of such a meter.

It should also be apparent that even though the meter socket adapter is described in this embodiment for testing socket type watt hour meters, it would be equally applicable that with this invention the adapter can be replaced with clip type connectors so as to test watt hour meters with screw type terminals which are referred to in the industry as "A" base meters.

**Claims**

1. A self-contained portable apparatus for testing the accuracy of a watt-hour meter (10) at its operational site, by being interposed electrically between the meter and the electrical power line, having power line terminals and load terminals (18) and a load (46), characterized in that it comprises phantom load means adapted for connection with said line terminals (18) and said load terminals (18), the phantom load means being a low load representative of a high load to the meter and including a loading transformer (46), a watt transducer (49) connected with said loading transformer, and means (66) for computing over a time period the watt-hours through the watt transducer relative to the watt-hours through the meter thereby to provide information representative of the accuracy of the meter.

2. Apparatus as claimed in claim 1, wherein there are means for obtaining from the watt transducer a signal representative of transducer watt-hours, and gate control means (42) adapted to enable gate means (45) for a time corresponding to a predetermined number of turns of a rotating disc (30) of the meter thereby corresponding to the watt-hours through the meter, such gate means receiving said signal from the watt transducer during said enabling time.

3. Apparatus as claimed in claim 2, wherein hand operable switch means (44) are adapted to activate the gate control means for a predetermined number of disc revolutions.

4. Apparatus as claimed in claim 3, wherein there are means to disable the gate control means for a predetermined number of disc revolutions.

5. Apparatus as claimed in claim 4, wherein the gate means is adapted to receive signals from the gate control means thereby to enable the gate means for a predetermined number of pulses corresponding to the number of disc revolutions.

6. Apparatus as claimed in claim 5, wherein display means (66) are provided to indicate digitally the percentage accuracy of the watt hour meter.

7. Apparatus as claimed in any one of claims 1 to 6, wherein the loading transformer (46) is adjustable.

8. Apparatus as claimed in claim 7, wherein there are frequency converter means and means for setting the frequency converter (67) thereby to adapt the watt transducer loading to correspond to a particular watt meter loading and operational characteristics.

9. Apparatus as claimed in any one of claims 1 to 8, which includes adapter means (11) with input contacts (19) for connection with the power line terminals and load terminals, said adapter being removably locatable in a meter receiving socket, and having output contacts (20) for connection with the meter, the meter being removably locatable with the adapter means and in connection with the output contacts of the adapter, and electrical conductor means from the adapter means connectable with said loading transformer.

10. Apparatus as claimed in claim 9, which includes reading means for counting a predetermined number of revolutions of the disc of the meter, said reading means including a light generating source (27) and light receiving means (29) adapted to be located on opposite sides of the disc, and the disc having an aperture (31) through which light from the light generating source is adapted to pass when the aperture is aligned between the generating and receiving means, and the receiving means having conductor means to pass a received signal to the gate control means.

11. Apparatus as claimed in claim 10, wherein the reading means includes articulated arm means (128, 129) mounted on the adapter means, the generating source and receiving means being mounted on the articulated arm means and being aligned axially relative to each other, the articulated arm means permitting movement of the generating source and receiving means relative to the disc to effect alignment with the aperture in the disc.

12. Apparatus as claimed in claim 11, wherein the watt transducer outputs a current signal, and including means for translating the current signal to a voltage, frequency converting means for converting the voltage to a representative frequency signal, the frequency converting means providing watt hour pulses proportional to the watt transducer output, and means for feeding such frequency output to the gate means.

13. Apparatus as claimed in any one of claims 9—12, wherein the phantom load includes a pair of loading windings (144, 145), said loading windings pair being adapted to apply a load to each coil of a pair of current coils of the meter.

14. Apparatus as claimed in claim 13, wherein the adapter means includes, in a three wire single phase system, means for isolating from the meter, the line conductors from the load conductors save for the power lines, whereby the power line terminals and the load terminals to the adapter are connected for normal power supply to the load terminals, and the meter phantom load is at reduced voltage.

15. Apparatus as claimed in claim 13 or claim 14 which includes means with the adapter means, in a three wire single phase system, for isolating from the meter, the line conductors and the load conductors save for substantially the 240 voltage power lines, whereby the power line terminals and load terminals to the adapter are connected for supplying power to the load terminals, and the meter phantom load is substantially at a 240 volt voltage, and the phantom loading current is in the range substantially between 5 amperes and 30 amperes.

16. Apparatus as claimed in any one of claims 1 to 15, characterized in that the computing means is adapted to calculate percentage error of the watt-hour meter.

17. A method of testing the accuracy of a watt-hour meter at its operational site comprising removing the meter from connection with electrical power line terminals and electrical load terminals in a meter receiving socket, locating an adapter in connection with the power line terminals and load terminals, connecting the meter to said adapter whereby the meter is connected through the adapter with the line and load terminals, characterized by connecting the meter with a loading transformer, applying through said loading transformer a phantom load being a low load representative of a higher load to the meter, connecting a watt transducer with said loading transformer thereby also applying said phantom load to the watt transducer, and computing over a time period the watt-hours through the watt transducer relative to the watt-hours through the meter thereby to provide information representative of the accuracy of the meter.

18. A method as claimed in claim 17, including obtaining from the watt transducer a signal representative of watt-hours, activating gate control means to enable gate means for a time corresponding to a predetermined number of revolutions of a rotating disc of the meter corresponding to the watt-hours through the meter, and passing said signal from the watt transducer to the gate means during said enabling time.

19. The method as claimed in claim 18, including counting a predetermined number of revolutions of the disc of the meter using a light source and light receiving means adapted to be located on opposite sides of the disc, the disc having an aperture through which light from the light source passes to the light receiving means when the aperture is aligned between the source and receiving means.

20. A method as claimed in either of claims 18 or 19, including operating a hand operable switch means to activate the gate control means for a predetermined number of disc revolutions.

21. A method as claimed in claim 20, including disabling the gate control means after a predetermined number of disc revolutions.

**Revendications**

1. Appareil portable autonome pour contrôler la précision d'un watt-heuremètre (10) à son site d'exploitation, en étant électriquement interposé entre le compteur et la ligne de courant électrique, ayant des bornes du réseau et des bornes de charge (18) et une charge (46) caractérisé en ce qu'il comprend un moyen formant charge fantôme adapté à une connexion avec lesdites bornes du réseau (18) et auxdites bornes de charge (18), le moyen formant charge fantôme ayant une faible charge représentative d'une charge supérieure au compteur et comprenant un transformateur de charge (46), un transducteur de watts (49) relié audit transformateur de charge, et un moyen (66) pour calculer, sur une période de temps, les watt-heures à travers le transducteur de watts relativement aux watt-heures à travers le compteur pour ainsi donner une information représentative de la précision du compteur.

2. Appareil selon la revendication 1 où des moyens sont prévus pour obtenir, du transducteur de watts, un signal représentatif des watt-heures du transducteur, et un moyen de commande de porte (42) est adapté à valider un moyen formant porte (45) pendant un temps correspondant à un nombre prédéterminé de tours d'un disque rotatif (30) du compteur correspondant ainsi aux watt-heures à travers le compteur, ledit moyen formant porte recevant ledit signal du transducteur de watts pendant ledit temps de validation.

3. Appareil selon la revendication 2 où des moyens commutateurs (44) à main sont adaptés à actionner le moyen de commande de porte pendant un nombre prédéterminé de tours du disque.

4. Appareil selon la revendication 3 où des moyens sont prévus pour inhiber le moyen de commande de porte pendant un nombre prédéterminé de tours du disque.

5. Appareil selon la revendication 4 où le moyen formant porte est adapté à recevoir des signaux du moyen de commande de porte pour ainsi valider le moyen formant porte pendant un nombre prédéterminé d'impulsions correspondant au nombre de tours du disque.

6. Appareil selon la revendication 5 où des moyens de visualisation (66) sont prévus pour indiquer numériquement le pourcentage de précision du watt-heuremètre.

7. Appareil selon l'une quelconque des revendications 1 à 6 où le transformateur de charge (46) est réglable.

8. Appareil selon la revendication 7 où il y a un moyen convertisseur de fréquence et un moyen pour ajuster le convertisseur de fréquence (67) pour ainsi adapter la charge du transducteur de watts pour correspondre à des caractéristiques particulières de charge et d'exploitation du wattmètre.

9. Appareil selon l'une quelconque des revendications 1 à 8 qui comprend un moyen adaptateur (11) avec des contacts d'entrée (19) pour connexion aux bornes du réseau et aux bornes de charge, ledit adaptateur pouvant être placé de manière amovible dans une douille de réception du compteur, et ayant des contacts de sortie (20) pour connexion au compteur, le compteur pouvant être mis en place de manière amovible avec le moyen adaptateur et en connexion avec les contacts de sortie de l'adaptateur et un moyen conducteur électrique du moyen d'adaptateur pouvant être connecté audit transformateur de charge.

10. Appareil selon la revendication 9 qui comprend un moyen de lecture pour compter un nombre prédéterminé de tours du disque du compteur, ledit moyen de lecture comprenant une source génératrice de lumière (27) et un moyen récepteur de lumière (29) pouvant être placés sur des côtés opposés du disque, et le disque ayant une ouverture (31) à travers laquelle la lumière de la source génératrice de lumière est adaptée à passer lorsque l'ouverture est alignée entre les moyens générateur et récepteur et le moyen récepteur ayant un moyen conducteur pour laisser passer un signal reçu vers le moyen de commande de porte.

11. Appareil selon la revendication 10 où le moyen de lecture comprend un moyen formant bras articulé (128, 129) monté sur le moyen adaptateur, la source génératrice et le moyen récepteur étant montés sur le moyen formant bras articulé et étant axialement alignés relativement l'un à l'autre, le moyen formant bras articulé permettant un mouvement de la source génératrice et du moyen récepteur relativement au disque pour effectuer un alignement avec l'ouverture dans le disque.

12. Appareil selon la revendication 11 où le transducteur de watts émet un signal de courant, et comprenant un moyen pour transformer le signal de courant en une tension, un moyen de conversion de fréquence pour convertir la tension en un signal représentatif de la fréquence, le moyen de conversion de fréquence produisant des impulsions de watt-heures proportionnelles à la sortie du transducteur de watts, et un moyen pour appliquer cette sortie de fréquence au moyen formant porte.

13. Appareil selon l'une quelconque des revendications 9 à 12 où la charge fantôme comprend une paire d'enroulements de charge (144, 145), ladite paire d'enroulements de charge étant adaptée à appliquer une charge à chaque bobine d'une paire de bobines du courant du compteur.

14. Appareil selon la revendication 13 où le moyen adaptateur comprend, dans un système monophasé à trois fils, un moyen pour isoler, du compteur, les conducteurs du réseau des conducteurs de charge sauf pour les lignes du réseau, pour qu'ainsi les bornes du réseau et les bornes de charge vers l'adaptateur soient connectées pour une alimentation normale en courant vers les bornes de charge et la charge fantôme du compteur soit à une tension réduite.

15. Appareil selon la revendication 13 ou 14 qui comprend un moyen avec le moyen adaptateur, dans un système monophasé à trois fils, pour isoler du compteur, les conducteurs du réseau et les conducteurs de charge à l'exception des lignes du réseau sensiblement à 240 volts, pour qu'ainsi les bornes du réseau et les bornes de charge vers l'adaptateur soient connectées pour fournir du courant aux bornes de charge, et la charge fantôme du compteur est sensiblement à une tension de 240 volts, et le courant de la charge fantôme est dans la plage sensiblement entre 5 ampères et 30 ampères.

16. Appareil selon l'une quelconque des revendications 1 à 15 caractérisé en ce que le moyen calculateur est adapté à calculer le pourcentage d'erreur du watt-heuremètre.

17. Méthode de contrôle de la précision d'un watt-heuremètre à son site d'exploitation consistant à retirer le compteur d'une connexion avec les bornes d'alimentation électrique et les bornes de charge électrique dans une douille de réception du compteur, à placer un adaptateur en connexion avec les bornes d'alimentation et les bornes de charge, à connecter le compteur audit adaptateur pour qu'ainsi le compteur soit connecté par l'adaptateur aux bornes d'alimentation et de charge, caractérisée par la connexion du compteur à un transformateur de charge, l'application par ledit transformateur de charge, d'une charge fantôme qui est une faible charge représentative d'une charge supérieure appliquée au compteur, la connexion d'un transducteur de watts audit transformateur de charge pour ainsi appliquer ladite charge fantôme au transducteur de watts et le calcul sur une période de temps des watt-heures à travers le transducteur de watts relativement aux watt-heures à travers le compteur pour ainsi produire une information représentative de la précision du compteur.

18. Méthode selon la revendication 17 consistant à obtenir du transducteur de watts un signal représentatif des watt-heures, à actionner le moyen de commande de porte pour valider le moyen formant porte pendant un temps correspondant à un nombre prédéterminé de tours d'un disque rotatif du compteur correspondant aux watt-heures à travers le compteur et à faire passer ledit signal du transducteur de watts au moyen formant porte pendant ledit temps de validation.

19. Méthode selon la revendication 18 consistant à compter un nombre prédéterminé de tours du disque du compteur en utilisant une souce de lumière et un moyen récepteur de lumière pouvant être placés sur des côtés opposés du disque, le disque ayant une ouverture par laquelle la lumière de la source de lumière passe vers le moyen récepteur de lumière lorsque l'ouverture est alignée entre la source et le moyen récepteur.

20. Méthode selon l'une quelconque des revendications 18 ou 19 consistant à faire fonctionner un moyen commutateur manuel pour actionner le moyen de commande de porte pendant un nombre prédéterminé de tours du disque.

21. Méthode selon la revendication 20 consistant à inhiber le moyen de commande de porte après un nombre prédéterminé de tours du disque.

**Patentansprüche**

1. Eine in sich geschlossene bzw. unabhängige, tragbare Vorrichtung zum Prüfen der Genauigkeit eines Wattstundezählers (10) an seiner Betriebsstätte, indem sie elektrisch zwischen dem Zähler und der elektrischen Starkstromleitung angebracht wird, mit Starkstromleitungsanschlußklemmen und Lastanschlußklemmen (18) und einer Last (46), dadurch gekennzeichnet, daß sie eine Phantomlasteinrichtung umfaßt, die dazu ausgebildet ist, mit den genannten Leitungsanschlußklemmen (18) und den genannten Lastanschlußklemmen (18) verbunden zu werden, daß die Phantomlasteinrichtung eine niedere Last ist, die dem Zähler gegenüber eine höhere Last darstellt, und einen Belastungstransformator (46), einen Watt-Meßwandler (49), der mit dem genannten Belastungstransformator verbunden est, und eine Einrichtung (66) umfaßt, der Über einen Zeitraum die durch den Watt-Meßwandler laufenden Wattstunden in bezug auf die durch den Zähler laufenden Wattstunden berechnet, um damit Information bezüglich der Genauigkeit des Zählers zu erstellen.

2. Vorrichtung nach Anspruch 1, worin eine Einrichtung zum Erhalten eines Signals vom Watt-Meßwandler vorgesehen ist, das die Meßwandler-Wattstunden repräsentiert, und eine Torsteuerungseinrichtung (42) dazu ausgebildet ist, die Toreinrichtung (45) für einen Zeitraum freizugeben, der einer vorgegebenen Anzahl von Umdrehungen einer Drehscheibe (30) des Zählers entspricht und dadurch den durch den Zähler laufenden Wattstunden entspricht, wobei die Toreinrichtung das genannte Signal vom Watt-Meßwandler während der genannten freigegebenen Zeitspanne erhält.

3. Vorrichtung nach Anspruch 2, worin eine händisch betätigbare Schaltereinrichtung (44) dazu ausgebildet ist, die Torsteuerungseinrichtung für eine vorgegebene Anzahl von Scheibenumdrehungen zu aktivieren.

4. Vorrichtung nach Anspruch 3, worin eine Einrichtung zum Sperren der Torsteuerungseinrichtung während einer vorgegebenen Anzahl von Scheibenumdrehungen vorgesehen ist.

5. Vorrichtung nach Anspruch 4, worin die Toreinrichtung dazu ausgebildet ist, Signale von der Torsteuerungseinrichtung zu empfangen und dadurch die Toreinrichtung für eine vorgegebene Anzahl von Impulsen freizugeben, die der Anzahl von Scheibenumdrehungen entspricht.

6. Vorrichtung nach Anspruch 5, worin eine Anzeigeeinrichtung (66) vorgesehen ist, um digital die Prozentsatzgenauigkeit des Wattstundenzählers anzuzeigen.

7. Vorrichtung nach einem der Ansprüche 1—6, worin der Belastungstransformator (46) einstellbar ist.

8. Vorrichtung nach Anspruch 7, worin eine Frequenzumwandlereinrichtung und eine Einrichtung zum Einstellen des Frequenzumwandlers (67) vorgesehen ist, um damit die Belastung des Watt-Meßwandlers so einzustellen, daß sie einer bestimmten Belastung und bestimmten Betriebscharakteristik des Wattstundenzählers entspricht.

9. Vorrichtung nach einem der Ansprüche 1—8, umfassend eine Adaptereinrichtung (11) mit Eingangskontakten (19) für die Verbindung mit den Starkstromleitungsanschlußklemmen und Lastanschlußklemmen, wobei der genannte Adapter lösbar in einer Zähleraufnahmesteckdose anbringbar ist und Ausgangskontakte (20) für die Verbindung mit dem Zähler aufweist, der Zähler lösbar mit der Adaptereinrichtung und in Verbindung mit den Ausgangskontakten des Adapters anbringbar ist und eine elektrische Leitereinrichtung von der Adaptereinrichtung mit dem genannten Belastungstransformator verbindbar ist.

10. Vorrichtung nach Anspruch 9, umfassend eine Ableseeinrichtung zum Zählen einer vorgegebenen Anzahl von Umdrehungen der Scheibe des Zählers, die genannte Ableseeinrichtung eine Lichterzeugungsquelle (27) und eine Lichtempfangseinrichtung (29) umfassend, die dazu ausgebildet sind, auf gegenüberliegenden Seiten der Scheibe angebracht zu werden, wobei die Scheibe mit einer Öffnung (31) versehen ist, durch die Licht von der Lichterzeugungsquelle durchtreten kann, wenn die Öffnung zwischen der Erzeugungs- und Empfangseinrichtung ausgerichtet ist, und die Empfangseinrichtung eine Leitereinrichtung besitzt, um ein empfangenes Signal an die Torsteuerungseinrichtung weiterzuleiten.

11. Vorrichtung nach Anspruch 10, worin die Ableseeinrichtung eine Glenkarmeinrichtung (128, 129) aufweist, die auf der Adaptereinrichtung montiert ist, und die Erzeugungsquelle und Empfangseinrichtung auf der Gelenkarmeinrichtung montiert und axial in bezug aufeinander ausgerichtet ist und die Gelenkarmeinrichtung die Bewegung der Erzeugungsquelle und Empfangseinrichtung relativ zur Scheibe zuläßt, um eine Ausrichtung mit der Öffnung in der Scheibe zu bewirken.

12. Vorrichtung nach Anspruch 11, worin der Watt-Meßwandler ein Stromsignal ausgibt, und enthaltend eine Einrichtung zum Umsetzen des Stromsignals in eine Spannung, eine Frequenzumwandlungseinrichtung zum Umwandeln der Spannung in ein repräsentatives Frequenzsignal, wobei die Frequenzumwandlungseinrichtung Wattstundenimpulse liefert, die proportional zur Ausgangsgröße des Watt-Meßwandlers sind, und eine Einrichtung für die Zuführung solcher Frequenzausgangsgrößen zur Toreinrichtung.

13. Vorrichtung nach einem der Ansprüche 9—12, worin die Phantomlast ein Paar von Belastungswicklungen (144, 145) aufweist und das genannte Paar von Belastungswicklungen dazu ausgebildet ist, eine Last an jede Wicklung eines Paares von Stromwicklungen des Zählers anzulegen.

14. Vorrichtung nach Anspruch 13, worin die Adaptereinrichtung in einem Einphasensystem mit drei Drähten eine Einrichtung für die Isolierung der Leiter der Leitung gegenüber den Leitern der Last mit Ausnahme der Starkstromleitungen vom Zähler aufweist, wodurch die Starkstromleitungsanschlußklemmen und die Lastanschlußklemmen zum Adapter für die normale Stromzufuhr mit den Lastanschlußklemmen verbunden sind, und die Phantomlast des Zählers auf verringerter Spannung ist.

15. Vorrichtung nach Anspruch 13 oder 14, die in einem Einphasensystem mit drei Drähten eine Einrichtung mit der Adaptereinrichtung zum Isolieren der Leiter der Leitung und der Leiter der Last mit Ausnahme im wesentlichen der Starkstromleitungen mit 240 Volt gegenüber dem Zähler aufweist, wodurch die Starkstromleitungsanschlußklemmen und die Lastanschlußklemmen zum Adapter für die Zufuhr von Strom zu den Lastanschlußklemmen verbunden sind, und die Phantomlast des Zählers im wesentlichen an einer Spannung von 240 Volt liegt und der Phantombelastungsstrom im wesentlichen innerhalb eines Bereiches von 5—30 Ampere liegt.

16. Vorrichtung nach einem der Ansprüche 1—15, dadurch gekennzeichnet, daß die Rechnereinrichtung dazu ausgebildet ist, den Fehlerprozentsatz des Wattstundenzählers zu berechnen.

17. Ein Verfahren zum Prüfen der Genauigkeit eines Wattstundenmessers an seiner Betriebsstätte umfassend Entfernen des Zählers von der Verbindung mit elektrischen Starkstromleitungs-Anschlußklemmen und elektrischen Lastanschlußklemmen in einer den Zähler aufnehmenden Steckdose, Anbringen eines Adapters in Verbindung mit den Starkstromleitungsanschlußklemmen und Lastanschlußklemmen, Verbinden des Zählers mit dem genannten Adapter, wodurch der Zähler durch den Adapter mit den Leitungs- und Lastanschlußklemmen verbunden ist, dadurch gekennzeichnet, daß der Zähler mit einem Belastungstransformator verbunden wird, der Zähler durch den genannten Belastungstransformator mit einer Phantomlast beaufschlagt wird, die eine geringe Last ist, aber dem Zähler eine Größere Last anzeigt, daß ein Watt-Meßwandler mit dem genannten Belastungstransformator verbunden wird und dadurch ebenfalls die genannte Phantomlast an den Watt-Meßwandler angelegt wird, und daß über eine Zeitspanne die durch den Watt-Meßwandler laufenden Wattstunden im Verhältnis zu den durch den Zähler laufenden Wattstunden berechnet werden, wodurch Information erstellt wird, die repräsentativ für die Genauigkeit des Zählers ist.

18. Ein Verfahren nach Anspruch 17, umfassend das Erhalten eines Signales, das die Wattstunden darstellt, vom Watt-Meßwandler, Aktivieren einer Torsteuerungseinrichtung, um eine Toreinrichtung für eine Zeitspanne freizugeben, die einer vorgegebenen Anzahl von Umdrehungen einer Drehscheibe des Zählers entspricht, die den durch den Zähler laufenden Wattstunden entspricht, und Weitergabe des genannten Signals vom Watt-Meßwandler an die Toreinrichtung während der genannten Freigabezeit.

19. Das Verfahren nach Anspruch 18, umfassend die Zählung einer vorgegebenen Anzahl von Umdrehungen der Scheibe des Zählers unter Verwendung einer Lichtquelle und Lichtempfangseinrichtung, die dazu ausgebildet sind, auf gegenüberliegenden Seiten der Scheibe angebracht zu werden, wobei die Scheibe eine Öffnung aufweist, durch die Licht von der Lichtquelle zur Lichtempfangseinrichtung durchtritt, wenn die Öffnung zwischen der Quelle und der Empfangseinrichtung ausgerichtet ist.

20. Ein Verfahren nach Anspruch 18 oder 19, umfassend die Betätigung einer händisch betätigbaren Schaltereinrichtung, um die Torsteuerungseinrichtung für eine vorgegebene Anzahl von Scheibenumdrehungen zu aktivieren.

21. Ein Verfahren nach Anspruch 20, umfassend das Sperren der Torsteuerungseinrichtung nach einer vorgegebenen Anzahl von Scheibenumdrehungen.

FIG. 1.

FIG. 2.

FIG. 3.

STORAGE
SPACE

START-STOP
SWITCH

Fig.4.